# EUROPEAN PATENT SPECIFICATION

(11) **EP 0 688 860 B1**
(45) Date of publication and mention of the grant of the patent: **21.05.2003**
(21) Application number: 94909293.6
(22) Date of filing: 09.03.1994
(51) Int. Cl.: C11D 17/00, C11D 7/30, C23G 5/028, C11D 7/50, C11D 11/00, C23G 5/02

(54) **PROCESS FOR PRODUCING CLEAN ARTICLE**
VERFAHREN ZUR HERSTELLUNG VON SAUBEREN GEGENSTAENDEN
PROCEDE POUR LA PRODUCTION D'ARTICLES PROPRES

(30) Priority: 12.03.1993 JP 7904093
(43) Date of publication of application: 27.12.1995
(73) Proprietor: DAIKIN INDUSTRIES, LIMITED, Osaka-shi, Osaka-fu 530 (JP)
(72) Inventor: IDE, Satoshi, Yodogawa Works of Daikin Ind. Ltd., Osaka 566 (JP); INABA, Takashi, Yodogawa Works of Daikin Ind.Ltd., Osaka 566 6 (JP); MATSUDA, T, Yodogawa Works of Daikin Ind.Ltd., Osaka 566 566 (JP); AOYAMA, H., Yodogawa Works of Daikin Ind. Ltd., Osaka 566 (JP)
(74) Representative: TER MEER STEINMEISTER & PARTNER GbR
(86) International application number: JP9400381
(87) International publication number: WO94020601

(56) References cited:
- EP-A- 0 512 885
- WO-A-94/28196
- JP-A- 4 028 798
- JP-A- 4 127 956
- JP-A- 4 130 197
- JP-A- 4 173 899
- DATABASE WPI Section Ch, Week 9223 Derwent Publications Ltd., London, GB; Class E15, AN 92-190049 XP002085875 & JP 04 127956 A (DAIKIN KOGYO KK) , 28 April 1992

## Description

### Industrial Application

This invention relates to production methods for cleaned articles, specifically to production methods for cleaned articles involving the cleaning of the surfaces of articles. Such methods are appropriate for washing away the rosin flux used for soldering on printed circuit boards, as well as for removing contaminants such as oils, wax, grease, and grease abrasives.

### Prior Art

Printed circuit boards are generally soldered with ICs and other parts. Solder flux is used to improve board solderability.

Such flux is broadly categorized into rosin flux and nonrosin or water-soluble flux. Among these, rosin flux is widely utilized in the electronics industries for mounting ICs and other parts onto printed boards.

Rosin flux, however, which could remain on such a board after the soldering process, will lower the resistance of the board and cause circuit damage. This is unfavourable. It is therefore necessary to clean rosin flux from such boards. Used for this cleaning have been hydrocarbon chlorides such as 1,1,1-trichloroethane and trichloroetylene, hydrocarbon chloride fluorides such as trichlorofluoroethane (CFC113) and dichlorotetrafluoroethane (CFC112), mixtures of some of those substances, or azeotropic mixtures of those substances or compounds and some organic solvents.

CFC113 in particular is widely used because of its excellent characteristics. It is incombustible, much less toxic, chemically highly stable, and it selectively removes contaminants rather than concurrently eroding the metals and plastics of the printed circuit board.

In recent years, however, it has been pointed out that some kinds of hydrocarbon chloride fluorides or hydrocarbon chlorides discharged into the atmosphere destroy the ozone layers of the stratosphere, causing serious damage to the earth's ecology and to mankind. As a result, the use or production of hydrocarbon chloride fluorides and hydrocarbon chlorides containing chlorine, which is very likely to destroy ozone layers, has been restricted.

Because of this, water with alkali or surface-active agents can be used as cleaning agents to wash away rosin flux or oil and grease. Such agents with water, however, are not widely utilized because they either have insufficient cleaning ability or because much energy and facilities are needed for drying articles cleaned in the process. Other reasons are because residue remains on the article after cleaning by such an agent or because the use of such agents requires costly facilities for water refining or wastewater disposal after use.

Known solvents for rosin flux, oil, or grease are organic solvents such as some aliphatic or aromatic hydrocarbon compounds, higher alcohol compounds, ether, and organic silicon compounds. These substances, however, have a relatively high boiling point and high viscosity. Accordingly, such substances remain on the surface of an article and are extremely difficult to clear away after being used as a cleaning agent. They thus cannot be used as cleaning agents. Moreover, some of these substances cannot be rinsed away even if water used for rinsing, because they are nonwater-soluble. Although other solvents are water-soluble, the use of water causes the above-mentioned problems. Consequently such solvents are not widely used.

### Objectives of the Invention

The present invention is based upon the discovery that specific aliphatic hydrocarbon fluorides are effective as rinsing agents for rinsing cleaning as mentioned above. Accordingly, this invention enables the use of such organic solvents being hard to use hitherto without the use of refined water. This enables cost reduction in the drying process and in wastewater-disposal facilities. Besides, use of the present invention also can prevent environmental destruction.

### Constituents of the Invention

The present invention relates to production methods for cleaned articles including the cleaning process where articles with contaminants that adhere thereto come into contact with an organic solvent (except hydrocarbon fluorides); and the rinsing process where the articles after passing through the cleaning process come into contact with one or more aliphatic hydrocarbon fluorides represented by the general formula: CₙFₘH₂ₙ₊₂₋ₘ (where n and m indicate positive integers of 4 ≦ n ≦ 6 and 2n-3≦ m< 2n+2, respectively).

Aliphatic hydrocarbon fluorides used in accordance with this invention as mentioned above are preferably one or more substances chosen from a compound group made up of C₄F₆H₄, C₄F₇H₃, C₄F₈H₂, C₄F₉H, C₅F₈H₄, C₅F₉H₃, C₅F₁₀H₂, C₅F₁₁H, C₆F₉H₅, C₆F₁₀H₄, C₆F₁₁H₃, C₆F₁₂H₂ and C₆F₁₃H.

Examples of such preferable compounds are listed below (with abbreviations in parentheses).
1,1,1,2,3,3,4-heptafluorobutane (CH₃CFHCF₂CFH₂) (347 mec)
1,1,1,2,4,4,4-heptafluorobutane (CH₃CFHCH₂CF₃) (347 mef)
1,1,2,2,3,4,4-heptafluorobutane (HCF₂CF₂CFHCF₂H) (347 pce)
1,1,2,3,4,4-hexafluorobutane (HCF₂CFHCFHCF₂H) (356 pee)
1,1,1,2,3,4,4-heptafluorobutane (CF₃CFHCFHCF₂H) (347 mee)
1,1,1,2,2,4,4-heptafluorobutane (CF₃CF₂CH₂CF₂H) (347 mcf)
2-trifluoromethyl-1,1,1,3-tetrafluoropropane ([CF₃]₂CHCFH₂)
(347 mmq)
1,1,1,2,2,4,4,4-octafluorobutane (CF₃CF₂CH₂CF₃) (338 mcf)
1,1,1,2,2,3,3,4-octafluorobutane (CF₃CF₂CF₂CFH₂) (338 mcc)
1,1,2,2,3,3,4,4-octafluorobutane (HCF₂CF₂CF₂CF₂H) (338 pcc)
1,1,1,2,3,3,4,4-octafluorobutane (CF₃CFHCF₂CF₂H) (338 mec)
2-trifluoromethyl-1,1,2,3,3-pentafluoropropane ([CF₂H]₂CFCF₃) (338 mpp)
2-trifluoromethyl-1,1,1,3,3-pentafluoropropane ([CF₃]₂CHCF₂H) (338 mmp)
1,1,1,2,2,3,3,4,4-nonafluorobutane (CF₃CF₂CF₂CF₂H)(329 mcc)
1,1,1,2,2,5,5,5-octafluoropentane (CF₃CF₂CH₂CH₂CF₃)(459 mff)
1,1,1,2,3,3,5,5,5-nonafluoropentane (CF₃CFHCF₂CH₂CF₃) (449 mec)
1,1,2,2,3,3,4,4,5-nonafluoropentane (HCF₂CF₂CF₂CF₂CFH₂) (449 qcc)
1,1,1,2,2,3,5,5,5-nonafluoropentane (CF₃CF₂CFHCH₂CF₃) (449 mfe)
1,1,1,2,2,4,5,5,5-nonafluoropentane (CF₃CF₂CH₂CFHCF₃) (449 mef)
1,1,1,2,2,4,4,5,5-nonafluoropentane (CF₃CF₂CH₂CF₂CF₂H) (449 pcf)
2-trifluoromethyl-1,1,1,2,4,4-hexafluorobutane ([CF₃]₂CFCH₂CF₂H) (449 mmyf)
1,1,1,2,2,3,4,5,5,5-decafluoropentane (CF₃CF₂CFHCFHCF₃) (4310 mee)
1,1,1,2,2,4,4,5,5,5-decafluoropentane (CF₃CF₂CH₂CF₂CF₃) (4310 mcf)
1,1,1,2,2,3,3,4,5,5-decafluoropentane (CF₃CF₂CF₂CFHCF₂H) (4310 pec)
2-trifluoromethyl-1,1,1,3,4,4,4-heptafluorobutane ([CF₃]₂CHCFHCF₃) (4310 mmze)
2-trifluoromethyl-1,1,1,2,3,3,4,4-octafluorobutane ([CF₃]₂CFCF₂CF₂H) (4211 mmyc)
2-trifluoromethyl-1,1,1,3,3,4,4,4-octafluorobutane ([CF₃]₂CHCF₂CF₃) (4211 mmzc)
1,1,2,2,3,3,4,4,5,6,6-undecafluorohexane (HCF₂CF₂CF₂CF₂CFHCF₂H) (5411 pcc) 1,1,2,2,3,3,4,4,5,5,6,6-dodecafluorohexane (HCF₂[CF₂]₄CF₂H) (5312 pcc)
2-trifluoromethyl-1,1,1,2,3,4,5,5,5-nonafluoropentane ([CF₃]₂CFCFHCFHCF₃) (5312 mmye)
2-trifluoromethyl-1,1,1,3,4,4,5,5,5-nonafluoropentane ([CF₃]₂CHCFHCF₂CF₃) (5312 mmze)
2-trifluoromethyl-1,1,1,2,4,4,5,5,5-nonafluoropentane ([CF₃]₂CFCH₂CF₂CF₃) (5312 mmyf)
1,1,1,2,2,3,3,4,4,5,5,6,6-tridecafluorohexane (CF₃[CF₂]₄CF₂H) (5213 pcc)

An organic solvent used in accordance with this invention as mentioned above is preferably one or more substances chosen from a compound group comprising aliphatic hydrocarbon compounds, aromatic hydrocarbon compounds, higher alcohol compounds, ether, and organic-silicon compounds.

Such an organic solvent preferably has a higher boiling point than the cleaning temperature ( 30° to 100°C), which is generally in a heated condition according to the present invention. Generally, organic solvents with a boiling point of 100°C or higher are especially preferable, but substances with a lower boiling point such as n-hexane, isooctane, and benzene can also be used.

Examples of preferable compounds for such an organic solvent are as follow.

Aliphatic hydrocarbon compounds: n-hexane, isoheptane, isooctane, gasoline, naphtha, mineral spirits, and kerosene

Aromatic hydrocarbon compounds: benzene, toluene, xylene, cyclohexane, methylcyclohexane, tetralin, decalin, dipentene, cymene, terpene, α-pinene, and turpentine oil

Higher alcohol compounds: 2-ethylbutyl alcohol, 2-ethylhexyl alcohol, nonyl alcohol, decyl alcohol, and cyclohexanol

Ether: ethylene glycol monoethyl ether, ethylene glycol monobutyl ether, diethylene glycol monoethyl ether, diethylene glycol monobutyl ether, diethylene glycol dimethyl ether, and diethylene glycol diethyl ether

Organic silicon compounds: dimethylpolysiloxane, cyclopolysiloxane, and octamethylcyclotetrasiloxane

Such organic solvents can be used with a nonionic surface-active agent and/or water added if necessary.

According to the present invention, one or more of the organic solvents indicated below and one or more aliphatic hydrocarbon fluorides indicated below should preferably be combined for use in the respective cleaning and rinsing processes.

For an organic solvent, kerosene, terpene, 2-ethylhexyl alcohol, ethylene glycol monoethyl ether, and octamethylcyclotetrasiloxane (kerosene and terpene in particular) should preferably be used. For an aliphatic hydrocarbon fluoride, 1,1,1,2,3,3,4-heptafluorobutane, 1,1,2,2,3,3,4,4-octafluorobutane, 1,1,1,2,2,3,4,5,5,5-decafluoropentane, 2-trifluoromethyl-1,1,1,2,3,3,4,4-octafluorobutane, 2-trifluoromethyl-1,1,1,2,3,4,5,5,5-nonafluoropentane (1,1,2,2,3,3,4,4-octafluorobutane, and 1,1,1,2,2,3,4,5,5,5-decafluoropentane in particular) should preferably be used.

According to the present invention, a mixture of an aliphatic hydrocarbon fluoride with one or more substances chosen as a rinsing assistant from a group of hydrocarbon compounds, lower alcohol compounds and ketone compounds can be used to rinse the article. In such a mixture, the assistant can generally be contained at a rate of less than 20% as opposed to the whole. Such an assistant at a rate of less than 10% may be more desirable because such a content rate often leaves the entire substance incombustible.

It is thus possible to mix such aliphatic hydrocarbon fluorides with assistants as mentioned above, but it is more effective if both substances comprise an azeotropic mixture. It is particularly preferable that an aliphatic hydrocarbon fluoride be used as mentioned above, along with one or more compounds chosen as rinsing assistants from a group comprising the above-mentioned hydrocarbon compounds, lower alcohol compounds, and ketone compounds creates an azeotropic or pseudoazeotropic composition.

Examples of compounds usable in such a rinsing assistant are as follow.

Hydrocarbon compounds: n-pentane, n-hexane, isohexane, n-heptane, isooctane, cyclopentane, cyclohexane, and methylcyclohexane.

Lower alcohol compounds: methyl alcohol, ethyl alcohol, n-propyl alcohol, isopropyl alcohol, and butyl alcohol

### Ketone: acetone and methylethylketone

Such rinsing assistants should preferably have a boiling point of 100°C to 20°C, or more preferably 100°C to 30°C. This is because such an agent is used in the steam-rinsing process or is circulated after rectification for reuse. It is further desirable that such an assistant mixed with an aliphatic hydrocarbon fluoride has nearly identical boiling points with the latter or makes an azeotropic or pseudo-azeotropic composition within the above-mentioned range of boiling points. If the latter case is adopted, the rinsing assistant alone can have a boiling point out of the range.

Examples of pseudo-azeotropic compositions recommended for such a rinsing agent are listed below.

| Pseudo-azeotropic compositions | Mexture rate(wt%) |
|---|---|
| 1,1,2,2,3,3,4,4-octafluorobutane/methanol | 96.3/3.7 |
| 1,1,2,2,3,3,4,4-octafluorobutane/ethanol | 98.9/1. |
| 2-trifluoromethyl-1,1,1,2,4,4-hexafluorobutane/methanol | 93.3/6.7 |
| 2-trifluoromethyl-1,1,1,2,4,4-hexafluorobutane/ethanol | 95.4/4.6 |
| 2-trifluoromethyl-1,1,1,2,4,4-hexafluorobutane/isopropanol | 95.8/4.2 |
| 1,1,1,2,2,3,4,5,5,5-decafluoropentane/methanol | 92.3/7.7 |
| 1,1,1,2,2,3,4,5,5,5-decafluoropentane/ethanol | 94.5/5.5 |
| 1,1,1,2,2,3,4,5,5,5-decafluoropentane/isopropanol | 95.9/4.1 |
| 1,1,1,2,2,4,4,5,5,5-decafluoropentane/methanol | 94.4/5.6 |
| 1,1,1,2,2,4,4,5,5,5-decafluoropentane/ethanol | 96.5/3.5 |
| 1,1,1,2,2,4,4,5,5,5-decafluoropentane/isopropanol | 97.0/3.0 |
| 2-trifluoromethyl-1,1,1,2,3,3,4,4-octafluorobutane/methanol | 96.7/3.3 |
| 2-trifluoromethyl-1,1,1,2,3,3,4,4-octafluorobutane/ethanol | 97.9/2.1 |
| 2-trifluoromethyl-1,1,1,3,4,4,5,5,5-nonafluoropentane/methanol | 91.0/9.0 |
| 2-trifluoromethyl-1,1,1,3,4,4,5,5,5-nonafluoropentane/ethanol | 93.0/7.0 |

In cleaning contaminants from surfaces in accordance with the methods of this invention, surfaces adhered with contaminants must first be put into contact with an organic solvent as mentioned above.

There are no restrictions on the contact of such a solvent and surfaces. The process can thus be implemented by any appropriate method such as by immersion of articles into the solvent or by spraying the solvent onto articles.

The temperature of the solvent in such contact is not particularly specified, but should ideally be slightly high within the noninflammable range of the solvent by heating. This is because a higher temperature accelerates removal of adhered contaminants.

In the immersion of articles in such a solvent, mechanical methods such as ultrasonic vibration, stirring, and brushing can be used to accelerate the removal of adhered contaminants.

The length of the period of contact of such a solvent and articles can be the necessary time to remove the contaminants to the extent desired.

In the next step, surfaces after being cleaned by contact with the organic solvent must be put into contact with a rinsing agent of an aliphatic hydrocarbon fluoride as mentioned above to conduct rinsing.

There are also no restrictions on the contact of such a rinsing agent and the surfaces, so that contact can be implemented by any appropriate method such as immersion of the articles into the rising-agent liquid, spraying the liquid on the articles, or cleaning the articles by using the liquid's steam.

To raise an rinsing effect, any of such rinsing methods can be repeated or mixed with another such method. Especially, combinations of immersion or spraying and steam rinsing have a much better rinsing effect. In such cases it is better that the steam-rinsing process be implemented after the rinsing process.

According to the present invention, it is preferable that the difference between the boiling point of such an organic solvent and the boiling point of such an aliphatic hydrocarbon fluoride be 50°C or more. This is because such a difference facilitates the separation of both substances after the cleaning process.

For thoroughly cleaning surfaces, it is also preferable (a) that the articles are immersed into a bath of such a solvent for removing contaminants at a temperature at least 10°C lower than the flash point of the organic solvent, (b) that the articles are immersed into a bath of such an aliphatic hydrocarbon fluoride in the rinsing process at a temperature at least 10°C lower than the boiling point of the fluoride, and (c) that the articles are steam-rinsed with the fluoride at its boiling point.

### Industrial Applicability

Because this invention uses specific aliphatic hydrocarbon fluorides as a rinsing agent, it has remarkable effects as mentioned in (1) to (5) below.
(1) The cleaning and rinsing agents used according to this invention contain no chlorine atoms. Accordingly, the invention causes no environmental problems such as contamination of the environment or destruction of the ozone layers.
(2) No water is used either in the cleaning process or in the rinsing process, so that this invention can simplify the processes and facilities. There is thus no need for considerable facilities, site, or operating costs for water refining or wastewater-disposal after use, because no water refining or disposal is necessary. Furthermore, the drying process needed if water is used is obviated.
(3) There is no danger of inflammation or explosion of the rinsing liquid in steaming it for cleaning, because an incombustible aliphatic hydrocarbon fluoride is used for rinsing liquid.
(4) It is unnecessary extensively to remodel the conventional cleaning facilities made for hydrocarbon chloride fluorides or hydrocarbon chlorides. The facilities, however, can be used only by replacing (a) such a cleaning agent with an organic solvent as mentioned above, and (b) the rinsing liquid currently used with an aliphatic hydrocarbon fluoride as mentioned above.
(5) The methods of the present invention allow sufficient removal of contaminants by using specific organic solvents and sufficient rinsing away of such an organic solvent by using an aliphatic hydrocarbon fluoride without using water. Furthermore, such an aliphatic hydrocarbon fluoride can be recovered and reused. If it is released into the environment, it is safe and does not damage the environment.

### Embodiments

The following is a detailed description of the embodiments of the present invention. These embodiments impose no limitations upon the invention, but considerable other variations are possible based upon the technical ideas of this invention.

### <Removal of rosin flux>

Printed circuit boards of 10cm × 10cm were coated with a rosin flux (trademarked as HI-15 by the Asahi Chemical Laboratory) by jet coating. The boards were predried and then heated at 250°C for one minute for use as test pieces. In the next step, the test pieces were cleaned and then rinsed under appropriate conditions with the cleaning and rinsing agents shown in Table 1. Steam rinsing was used concomitantly in some cases.

As the resulting effects of removing the rosin flux, the appearances of the test pieces and the quantities of ionic residues on them after the cleaning and rinsing processes are shown in Table 2. The quantities of the ionic residues were measured with an Omegameter 600SMD (Nihon Alphametals Co., Ltd.).

**Table 1 (A)**

| Example | Cleaning | Rinsing | Steam rinsing |
|---|---|---|---|
| 1 | Kerosene (boiling point 180 °C ) at 40°C for 30 seconds | 1,1,1,2,3,3,4-heptafluorobutane (boiling point 42°C ) at 25 °C for 30 seconds | Same as the left at 42 °C for 30 seconds |
| 2 | Terpene (boiling point 150 °C ) at 60°C for 30 seconds | 1,1,2,2,3,3,4,4-octafluorobutane (boiling point 44°C ) at 25 °C for 30 seconds | Same as the left at 44 °C for 30 seconds |
| 3 | 2-ethylhexyl alcohol (boiling point 185 °C ) at 60°C for 30 seconds | 1,1,1,2,2,3,4,5,5,5-decafluoropentane (94.5 wt%)/ethanol (5.5 wt%) (boiling point 53 °C ) at 25°C for 30 seconds | Same as the left at 53 °C for 30 seconds |
| 4 | Ethylene glycol monoethyl ether (boiling point 135 °C ) at 40 °C for 30 seconds | 2-trifluoromethyl-1,1,1,2,3,3,4,4-octafluorobutane (96.7 wt%)/methanol (3.3 wt%) (boiling point 42 °C ) at 25 °C for 30 seconds | Same as the left at 42 °C for 30 seconds |
| 5 | Octamethylcyclotetrasiloxane (boiling point 175 °C ) at 60 °C for 30 seconds | 2-trifluoromethyl-1,1,1,2,3,4,5,5,5-nonafluoropentane (boiling point 65 °C ) at 25 °C for 30 seconds | Same as the left at 65 °C for 30 seconds |
| 6 | Terpene (boiling point 150 °C ) at 60°C for 30 seconds | 1,1,2,2,3,3,4,4-octafluorobutane (boiling point 44 °C ) at 25 °C for 30 seconds | None |

**Table 1 (B)**

| Comparative Example | Cleaning | Rinsing | Steam rinsing |
|---|---|---|---|
| 1 | Terpene (boiling point 150 °C ) at 60°C for 30 seconds | Terpene (boiling point 150°C ) at 60 °C for 30 seconds | None |
| 2 | Terpene (boiling point 150 °C ) at 60°C for 30 seconds | Water (boiling point 100°C ) at 60 °C for 30 seconds | None |

**Table 2**

| | Appearance | Ionic residues (µg NaCl/in²) |
|---|---|---|
| Example 1 | Surface cleaned | 4.4 |
| Example 2 | Surface cleaned | 3.6 |
| Example 3 | Surface cleaned | 2.2 |
| Example 4 | Surface cleaned | 3.2 |
| Example 5 | Surface cleaned | 3.5 |
| Example 6 | Surface cleaned | 5.5 |
| Comparative Example 1 | Not dried | 18.0 |
| Comparative Example 2 | White residue | 25.0 |

### <Removal of machining oil>

100 mesh-metal gauze of 5cm × 5cm were coated with a machining oil (trademarked as PG-3080 by Nihon Machining Oils Co., Ltd.) to create test pieces. In the next step, the test pieces were cleaned and then rinsed under the conditions indicated in Table 1 with the cleaning and rinsing agents shown in Table 1. This was done to evaluate the effect of this invention for removing machine oils.

The resulting appearances of the test pieces and the degreasing rates after the treatment are shown in Table 3. The grease-cleaning rates were calculated based on the weights of the test pieces with machining oil measured before and after the treatment.

**Table 3**

| | Appearance | Grease-cleaning rate (%) |
|---|---|---|
| Example 1 | Surface cleaned | 99.9 |
| Example 2 | Surface cleaned | 99.9 |
| Example 3 | Surface cleaned | 99.9 |
| Example 4 | Surface cleaned | 99.9 |
| Comparative Example 1 | Not dried | 50.5 |
| Comparative Example 2 | Not dried | 80.3 |

From the above results, Examples 1 to 6 of this invention show that the methods according with this invention have a sufficient effect of cleaning away rosin flux or oils.

Furthermore, the organic solvents and aliphatic hydrocarbon fluorides used in Examples 1 to 6 can be separated sufficiently and removed by heating the liquids after the cleaning.

## Claims

1. A cleaning method for articles including a cleaning process where surfaces with adhered contaminants are put into contact with an organic solvent except hydrocarbon fluorides; and a rinsing process where the surfaces after completion of the cleaning process are put into contact with one or more aliphatic hydrocarbon fluorides represented by the general formula:
CₙFₘH₂ₙ₊₂₋ₘ,
where n and m indicate positive integers of 4≤n≤6 and 2n-3≤m<2n+2, respectively.

2. The cleaning method described in the above Claim 1 using an organic solvent having a boiling point of at least 100°C.

3. The cleaning method described in the above Claims 1 or 2 using one or more aliphatic hydrocarbon fluorides chosen from a compound group comprising C₄F₆H₄, C₄F₇H₃, C₄F₈H₂, C₄F₉H, C₅F₈H₄, C₅F₉H₃, C₅F₁₀H₂, C₅F₁₁H, C₆F₉H₅, C₈F₁₀H₄, C₆F₁₁H₃, C₆F₁₂H₂, and C₆F₁₃H.

4. The cleaning method described in the above Claims 1, 2, or 3 using one or more substances chosen from a group comprising aliphatic hydrocarbon compounds, aromatic hydrocarbon compounds, higher alcohol compounds, ether, and organic silicon compounds as organic solvents.

5. The cleaning method described in the above Claim 4 using one or more substances chosen from a group comprised of kerosene, terpene, 2-ethylhexyl alcohol, ethylene glycol monoethyl ether, and octamethylcyclotetrasiloxane as organic solvents; and also using one or more substances chosen from a group comprising 1,1,1,2,3,3,4-heptafluorobutane, 1,1,2,2,3,3,4,4-octafluorobutane, 1,1,1,2,2,3,4,5,5,5-decafluoropentane, 2-trifluoromethyl-1,1,1,2,3,3,4,4-octafluorobutane, and 2-trifluoromethyl-1,1,1,2,3,4,5,5,5-nonafluoropentane as aliphatic hydrocarbon fluorides.

6. The cleaning method described in any of the above Claims 1 through 5, including a rinsing process with a mixture of one or more substances chosen as a rinsing assistant from a group comprising hydrocarbon compounds, lower alcohol and ketone compounds, and an aliphatic hydrocarbon fluoride.

7. The cleaning method described in the above Claim 6 using one or more substances having a boiling point of 100° to 20°C, chosen from a group comprised of hydrocarbon compounds, lower alcohol and ketone compounds.

8. The cleaning method described in the above Claims 6 or 7 using an azeotropic or pseudo-azeotropic mixture of such rinsing assistant and aliphatic hydrocarbon fluoride.

9. The cleaning method described in any of the above Claims 1 through 8 including a steam-rinsing process subsequent to the rinsing process.

10. The cleaning method described in any of the above Claims 1 through 9, using an organic solvent and an aliphatic hydrocarbon fluoride the difference of whose boiling points is 50°C or more.

11. The cleaning method described in any of the above Claims 1 through 10, including (a) the cleaning process where articles are immersed in a bath of organic solvent at a temperature at least 10°C lower than its flash point, (b) the rinsing process where the articles are immersed in a bath of aliphatic hydrocarbon fluoride at a temperature at least 10°C lower than its boiling point, and (c) the steam-cleaning process where the articles are steam-cleaned at the boiling point of the aliphatic hydrocarbon fluoride.

## Patentansprüche

1. Reinigungsverfahren für Gegenstände, einschließlich einem Reinigungsverfahren, bei dem Oberflächen mit anhaftenden Verunreinigungen mit einem organischen Lösungsmittel, ausgenommen Kohlenwasserstofffluoride, in Kontakt gebracht werden; und einem Spülverfahren, bei dem die Oberflächen nach Vervollständigung des Reinigungsverfahrens in Kontakt gebracht werden mit einem oder mehreren aliphatischen Kohlenwasserstofffluoriden der allgemeinen Formel:
CₙFₘH₂ₙ₊₂₋ₘ,
worin n und m positive ganze Zahlen von 4≤n≤6 und 2n-3≤m<2n+2, respective, bedeuten.

2. Reinigungsverfahren nach Anspruch 1, bei dem ein organisches Lösungmittel mit einem Siedepunkt von mindestens 100°C verwendet wird.

3. Reinigungsverfahren nach Anspruch 1 oder 2, bei dem ein oder mehrere aliphatische Kohlenwasserstofffluoride verwendet werden, gewählt aus einer Verbindungsgruppe, umfassend C₄F₆H₄, C₄F₇H₃, C₄F₈H₂, C₄F₉H, C₅F₈H₄, C₅F₉H₃, C₅F₁₀H₂, C₅F₁₁H, C₆F₉H₅, C₆F₁₀H₄, C₆F₁₁H₃, C₆F₁₂H₂, und C₆F₁₃H.

4. Reinigungsverfahren nach den Ansprüchen 1, 2 oder 3, wobei eine oder mehrere Substanzen verwendet werden, gewählt aus der Gruppe, umfassend aliphatische Kohlenwasserstoffverbindungen, aromatische Kohlenwasserstoffverbindungen, höhere Alkoholverbindungen, Ether und organische Siliciumverbindungen als organische Lösungsmittel.

5. Reinigungsverfahren nach Anspruch 4, bei dem eine oder mehrere Substanzen verwendet werden, gewählt aus einer Gruppe umfassend Kerosin, Terpen, 2-Ethylhexylalkohol, Ethylenglykolmonoethylether und Octamethylcyclotetrasiloxan als organische Lösungsmittel; und ebenso eine oder mehrere Substanzen verwendet werden. gewählt aus der Gruppe, umfassend 1,1,1,2,3,3,4-Heptafluorbutan, 1,1,2,2,3,3,4,4-Octafluorbutan, 1,1,1,2,2,3,4,5,5,5-Decafluorpentan, 2-Trifluormethyl-1,1,1,2,3,3,4,4-octafluorbutan, und 2-Trifluormethyl-1,1,1,2,3,4,5,5,5-nonafluorpentan als aliphatische Kohlenwasserstofffluoride.

6. Reinigungsverfahren nach mindestens einem der Ansprüche 1 bis 5, einschließlich einem Spülverfahren mit einer Mischung aus einer oder mehreren Substanzen, gewählt als Spülhilfsmittel aus einer Gruppe, umfassend Kohlenwasserstoffverbindungen, niedere Alkohol- und Ketonverbindungen und einem aliphatischen Kohlenwasserstofffluorid.

7. Reinigungsverfahren nach Anspruch 6, wobei eine oder mehrere Substanzen mit einem Siedepunkt von 100 bis 20°C verwendet werden, gewählt aus der Gruppe, umfassend Kohlenwasserstoffverbindungen, niedere Alkohol- und Ketonverbindungen.

8. Reinigungsverfahren nach den Ansprüchen 6 oder 7, wobei eine azeotrope oder pseudoazeotrope Mischung aus einem solchen Spülhilfsmittel und einem aliphatischen Kohlenwasserstofffluorid verwendet wird.

9. Reinigungsverfahren nach mindestens einem der Ansprüche 1 bis 8, einschließlich einem Dampfspülverfahren im Anschluss an das Spülverfahren.

10. Reinigungsverfahren nach mindestens einem der Ansprüche 1 bis 9, wobei ein organisches Lösungsmittel und ein aliphatisches Kohlenwasserstofffluorid verwendet wird, deren Unterschied in den Siedepunkten 50°C oder mehr beträgt.

11. Reinigungsverfahren nach mindestens einem der Ansprüche 1 bis 10, einschließlich (a) des Reinigungsverfahrens, bei dem Gegenstände in ein Bad aus organischem Lösungsmittel bei einer Temperatur von mindestens 10°C unterhalb dessen Flammpunkt eingetaucht werden, (b) des Spülverfahrens, bei dem die Gegenstände in ein Bad aus aliphatischem Kohlenwasserstofffluorid bei einer Temperatur von mindestens 10°C unterhalb dessen Siedepunkt eingetaucht werden, und (c) des Dampf-Reinigungsverfahrens, bei dem die Gegenstände beim Siedepunkt des aliphatischen Kohlenwasserstofffluorids dampfgereinigt werden.

## Revendications

1. Procédé de nettoyage pour articles comprenant un procédé de nettoyage dans lequel des surfaces auxquelles adhèrent des agents contaminants sont mises en contact avec un solvant organique, à l'exception des fluorures hydrocarbonés; et un procédé de rinçage dans lequel les surfaces, après achèvement du procédé de nettoyage, sont mises en contact avec un ou plusieurs fluorures hydrocarbonés aliphatiques représentés par la formule générale :
CₙFₘH_{2n+2-m,}
dans laquelle n et m indiquent des nombres entiers positifs répondant aux inégalités suivantes : 4 ≤ n ≤ 6 et 2n-3 ≤ m < 2n+2, respectivement.

2. Procédé de nettoyage selon la revendication 1, utilisant un solvant organique ayant un point d'ébullition d'au moins 100°C.

3. Procédé de nettoyage selon les revendications 1 ou 2, utilisant un ou plusieurs fluorures hydrocarbonés aliphatiques choisis dans un groupe de composés comprenant les suivants C₄F₆H₄, C₄F₇H₃, C₄F₈H₂, C₄F₉H, C₅F₈H₄, C₅F₉H₃, C₅F₁₀H₂, C₅F₁₁H, C₆F₉H₅, C₆F₁₀H₄, C₆F₁₁H₃, C₆F₁₂H₂ et C₆F₁₃H.

4. Procédé de nettoyage selon les revendications 1, 2 ou 3, utilisant une ou plusieurs substances choisies dans un groupe comprenant les composés hydrocarbonés aliphatiques, les composés hydrocarbonés aromatiques, les composés d'alcools supérieurs, les éthers et les composés de silicone organiques comme solvants organiques.

5. Procédé de nettoyage selon la revendication 4, utilisant une ou plusieurs substances choisies dans un groupe comprenant le kérosène, le terpène, l'alcool de 2-éthylhexyle, le monoéthyléther d'éthylèneglycol et l'octaméthyl-cyclotétrasiloxane comme solvants organiques; et utilisant également une ou plusieurs substances choisies dans le groupe comprenant le 1,1,1,2,3,3,4-heptafluorobutane, le 1,1,2,2,3,3,4,4-octafluorobutane, le 1,1,1,2,2,3,4,5,5,5-décafluoropentane, le 2-trifluorométhyl-1,1,1,2,3,3,4,4-octafluorobutane et le 2-trifluorométhyl-1,1,1,2,3,4,5,5,5-nonafluoropentane comme fluorures hydrocarbonés aliphatiques.

6. Procédé de nettoyage selon l'une quelconque des revendications 1 à 5, comprenant un procédé de rinçage avec un mélange d'une ou plusieurs substances choisies comme auxiliaire de rinçage dans un groupe comprenant des composés hydrocarbonés, des composés d'alcools inférieurs et de cétones, et un fluorure hydrocarboné aliphatique.

7. Procédé de nettoyage selon la revendication 6, utilisant une ou plusieurs substances ayant un point d'ébullition de 100°C à 20°C, choisies dans un groupe constitué des composés hydrocarbonés, des composés d'alcools inférieurs et des cétones.

8. Procédé de nettoyage selon la revendication 6 ou 7, utilisant un mélange azéotropie ou pseudo-azéotropie de cet auxiliaire de rinçage et de ce fluorure hydrocarboné aliphatique.

9. Procédé de nettoyage selon l'une quelconques des revendications 1 à 8, comprenant un procédé de rinçage à la vapeur d'eau à la suite du procédé de rinçage.

10. Procédé de nettoyage selon l'une quelconque des revendications 1 à 9, utilisant un solvant organique et un fluorure hydrocarboné aliphatique, dont les points d'ébullition présentent une différence de 50°C ou plus.

11. Procédé de nettoyage selon l'une quelconque des revendications 1 à 10, comprenant (a) le procédé de nettoyage dans lequel des articles sont immergés dans un bain de solvant organique à une température au moins 10°C inférieure à son point d'éclair, (b) le procédé de rinçage dans lequel les articles sont immergés dans un bain de fluorure hydrocarboné aliphatique à une température au moins 10°C inférieure à son point d'ébullition, et (c) le procédé de nettoyage à la vapeur d'eau dans lequel les articles sont nettoyés à la vapeur d'eau au point d'ébullition du fluorure hydrocarboné aliphatique.
